Europäisches Patentamt

European Patent Office

Office européen des brevets

(19)

(11) Numéro de publication: **0 239 434**
**B1**

(12) **FASCICULE DE BREVET EUROPEEN**

(45) Date de publication du fascicule du brevet: **20.06.90**

(51) Int. Cl.⁵: **B 41 J 2/335**

(21) Numéro de dépôt: **87400366.8**

(22) Date de dépôt: **19.02.87**

(54) **Tête d'écriture thermique de type série pour imprimante.**

(30) Priorité: **21.02.86 FR 8602392**

(43) Date de publication de la demande:
**30.09.87 Bulletin 87/40**

(45) Mention de la délivrance du brevet:
**20.06.90 Bulletin 90/25**

(84) Etats contractants désignés:
**BE DE ES GB IT NL**

(56) Documents cités:
**DE-A-2 246 436**
**FR-A-2 548 593**
**GB-A-2 145 667**
**US-A-3 968 500**
**US-A-4 361 844**

(73) Titulaire: **SOCIETE D'APPLICATIONS
GENERALES D'ELECTRICITE ET DE MECANIQUE
SAGEM
6, Avenue d'Iéna
F-75783 Paris Cédex 16 (FR)**

(72) Inventeur: **Vegeais, Patrick
16 rue Félicien David
F-78100 Saint Germain en Laye (Yvelines) (FR)**
Inventeur: **Bergougnoux, Michel
6 rue du Centre
F-95130 Franconville (Val-d'Oise) (FR)**

(74) Mandataire: **Bloch, Gérard et al
2, square de l'Avenue du Bois
F-75116 Paris (FR)**

Courier Press, Leamington Spa, England.

## Description

La présente invention concerne une tête d'impression, ou d'écriture, thermique, pour imprimantes de systèmes de transmission de données, notamment de systèmes de traitement de textes.

Une tête thermique d'écriture comporte généralement une pluralité d'éléments résistifs agencés pour être parcourus par un courant et donc chauffer, et coopérer soit directement avec un support d'impression, un papier thermosensible, soit indirectement avec un support d'impression ordinaire, par l'intermédiaire d'un ruban enduit d'une encre fondant à la chaleur des éléments. Dans le premier cas, il s'agit d'une impression thermique directe, dans le second cas, d'une impression par transfert thermique.

Il peut s'agir d'une impression thermique de type série, et alors la tête, mobile, comporte au moins une barrette, généralement verticale, d'éléments, alignés selon une direction orthogonale au sens du déplacement rectiligne, durant l'impression d'une ligne de caractères, correspondant à la hauteur de la barrette, d'un chariot-support de la tête.

Il peut aussi s'agir d'une impression thermique de type ligne, et, dans ce cas, la tête, immobile, comporte une rangée généralement horizontale de nombreux éléments, de largeur compatible avec la largeur du support destiné à être imprimé au cours de son défilement orthogonalement à la rangée d'éléments.

A partir d'une carte dite imprimante, ou d'une carte de transition, les éléments résistifs d'impression doivent être alimentés en courant durant des intervalles de temps déterminés en fonction des caractères, ou graphismes, à imprimer. A cet effet, ces éléments résistifs sont reliés électriquement à la carte en question par des conducteurs agencés pour coopérer mécaniquement et électriquement avec les bornes d'un connecteur solidaire de la carte.

Les solutions de ce problème de connexion, les plus répandues, mettent en oeuvre un connecteur femelle spécifique, à une seule rangée de bornes, solidaire de la carte.

Les éléments résistifs sont formés sur un substrat de base, généralement une céramique.

Les têtes d'impression ligne comportent, cela a déjà été souligné, un grand nombre d'éléments chauffants, donc formés sur un substrat de grande dimension. On utilise souvent des têtes à 1728 éléments. La céramique étant un matériau onéreux, la durée de vie de ces têtes est facilement celle des imprimantes, d'autant plus que ses éléments sont relativement peu sollicités. Elles n'ont par conséquent pas besoin d'être remplacées.

Les têtes d'impression série comporte beaucoup moins d'éléments, leur substrat de base est beaucoup moins encombrant et donc beaucoup moins cher, et il est parfaitement admis que ces têtes puissent être interchangeables et interchangées. Et elles le sont.

A titre d'exemple, il est admis qu'une tête série, pour l'impression de caractères de 3 mm de haut à l'aide de 8 points par millimètre, comportant donc une barrette de 24 éléments, n'ait qu'une durée de vie correspondant à l'impression de 10 000 formats classiques A4.

Une tête série à 24 éléments chauffants, par exemple, comporte, non pas 48 conducteurs, ni 25 dont 1 conducteur de masse, mais 30 conducteurs dont 6 conducteurs de masse pour tenir compte des sections des conducteurs et des densités de courant. Mais il s'agit quand même d'un nombre élevé.

Si le pas des conducteurs de connexion, formés sur le substrat de la tête, correspond au pas des bornes du connecteur de la carte, le substrat, monté sur un support, peut directement jouer le rôle de connecteur mâle pour le connecteur femelle de la carte. On conçoit toutefois, aisément, qu'en cas d'un grand nombre de conducteurs, comme 30, pareille solution ne soit pas satisfaisante, car elle repose sur un substrat de grande taille, donc cher. Cette solution peut même être proscrite en cas de conducteurs en nombre limité, en raison du faible éventail des dimensions de connecteurs femelles de carte qui limite la réduction des dimensions de substrats. Et l'implantation, sur le substrat, d'un convertisseur de commande série-parallèle ne pallie pas pour autant l'inconvénient.

Si le nombre des conducteurs, ou pistes conductrices, est important, d'une part, et que leur pas est petit, pour avoir été formés sur un substrat d'encombrement aussi réduit que possible, d'autre part, et cela reste vrai avec un petit nombre de conducteurs en raison des dimensions minimales des connecteurs femelles de carte, la solution consiste alors à interposer un film souple, support de pistes, à portion de connexion élargie pour convertir le pas.

On connaît des têtes d'impression série à film souple, utilisé en "trainard", connectant directement le substrat, avec ses éléments chauffants, aux cartes électroniques de commande de l'alimentation en courant. Dans ces formes de réalisation, le film souple emprunte un trajet compliqué, et le remplacement de ces têtes, avec leur trainard, ne peut être effectué que par une personne qualifiée, et non pas par l'opérateur de l'imprimante sans le moindre outillage.

On connaît encore des têtes d'impression série comportant, sur une plaquette, un substrat d'éléments chauffants, avec les éléments chauffants et des portions de conducteurs associées, un support de connexion et un film souple double face, avec des pistes imprimées sur ses deux faces, refondu ou pressé sur le substrat à une extrémité pour relier les pistes, sur sa face tournée vers la plaquette, aux portions de conducteurs du substrat, et collé sur le support de connexion à l'autre extrémité, où les pistes sont imprimées sur son autre face pour pouvoir coopérer avec les bornes du connecteur femelle de carte. Une tête d'un type similaire est décrite dans le document FR-A-2 548 593.

Sous réserve que la plaquette de ces têtes soit

rigide, que ces têtes soient compactes, et donc que la longueur de leur film souple soit faible, elles peuvent être facilement démontées par l'opérateur de l'imprimante.

Cependant, tous les contacts de connexion de ces têtes, à l'extrémité de connexion du film souple à trous métallisés, sont disposés sur une même face: ou bien la connexion s'effectue par connecteurs femelle spécifiques, à une seule rangée de bornes, qui ont effectivement été développés à cet effet, comme rappelé ci-dessus, ou bien la connexion s'effectue par l'intermédiaire d'un connecteur supplémentaire du type mâle.

Certes, le document US-A-4 361 844 enseigne une tête d'écriture thermique comprenant un substrat d'éléments d'écriture, une plaquette de connexion double face et une plaquette de commande, ces trois éléments étant montés de façon amovible sur un support emboîtable dans un connecteur femelle. Si une telle disposition au demeurant simple, autorise un démontage et un remontage faciles, outre le fait que cette tête d'écriture ne comporte pas de film souple de pistes conductrices, elle ne permet pas pour autant d'utiliser des connecteurs classiques du commerce, les contacts d'entrée n'étant imprimés que d'un seul côté de la plaquette de connexion.

La présente invention vise donc à proposer une tête d'impression thermique série qui puisse être reliée à un connecteur femelle classique du commerce, et qui soit facilement démontable.

A cet effet, la présente invention concerne une tête d'écriture thermique de type série pour imprimante, comprenant un substrat, sur celui-ci, des éléments résistifs d'écriture avec des conducteurs associés, un support de connexion à deux faces, un film souple, porteur de pistes conductrices reliées électriquement aux conducteurs du substrat, et solidaire, par ses deux portions d'extrémité, du substrat et du support de connexion, respectivement, caractérisée par le fait que les pistes du film sont imprimées sur une seule de ses faces et le support de connexion double face porte des conducteurs respectivement reliés électriquement aux pistes du film et imprimés sur ses deux faces, les conducteurs, imprimés sur la face du support de connexion opposée à celle tournée vers le film, étant reliés aux pistes associées du film par des trous métallisés.

Grâce à l'invention, le film souple est imprimé simple face, ce qui constitue déjà un premier avantage, et, le support de connexion étant imprimé double face, la tête peut être connectée à un connecteur classique de type femelle à deux rangées de contacts, d'un prix moyen très faible, ce qui constitue un deuxième et important avantage, sans parler de la simplicité de démontage et remontage de la tête.

Malgré sa simplicité, la tête d'écriture de l'invention n'en est pas moins originale. Certes, les circuits double face étaient déjà connus. Mais la combinaison d'un circuit double face et d'un film de connexion simple face dans une tête d'écriture ne débouche pas sur l'invention mais sur un support et un film de connexion tous deux double face ou à trous métallisés, puisque dans une tête d'écriture à film de connexion simple face, le substrat et le support de connexion sont obligatoirement disposés de part et d'autre du film.

Par ailleurs, on notera que le pas des conducteurs imprimés sur le support de connexion double face de la tête de l'invention est plus grand que celui des conducteurs des supports simple face agencés pour coopérer avec les connecteurs spécifiques.

L'invention sera mieux comprise à l'aide de la description suivante de la forme de réalisation préférée de la tête d'écriture de l'invention, en référence aux dessins annexés sur lesquels

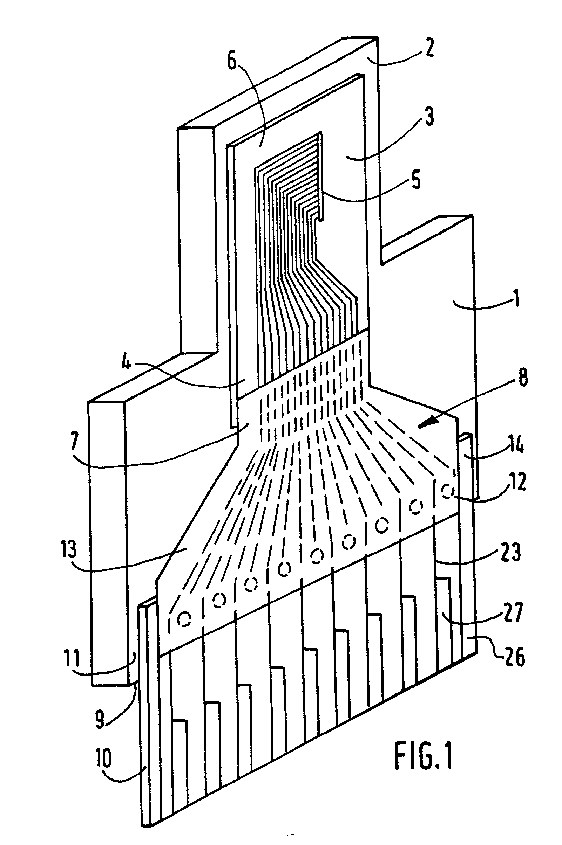

la figure 1 représente une vue en perspective de la tête d'écriture de l'invention, et

la figure 2 représente une vue en coupe, selon un plan parallèle à son plan de symétrie générale, de la tête de la figure 1.

La tête d'écriture thermique d'imprimante représentée sur les dessins est réalisée sur une plaquette rigide 1, de forme générale parallélépipédique, à plan de symétrie longitudinal, avec une portion d'écriture 2 de largeur réduite. Sur la portion d'écriture 2, et légèrement au-delà, est fixé, par collage, un substrat de céramique 3 de forme rectangulaire. Sur le substrat 3 sont déposés des éléments résistifs 15 alignés parallèlement au plan de symétrie générale de la tête et constituant une barrette d'écriture 5. Chacun de ces éléments résistifs est relié à deux conducteurs pour être parcouru, pendant des intervalles de temps déterminés, par un courant de chauffage et donc d'impression.

Sur la portion d'extrémité 4 du substrat 3, destinée à être tournée vers l'imprimante, l'autre portion d'extrémité 6 étant destinée à s'étendre plus ou moins le long d'un support d'impression, est fixée une petite portion d'extrémité 7 d'un film souple 8, sensiblement de même largeur que le substrat 3 et de petite longueur. Sur la bande d'extrémité 11 de la portion élargie de la plaquetre 1, et en saillie au-delà de son bord transversal 9, est fixé un support de connexion 10, de forme rectangulaire, sensiblement de même largeur que la plaquette 1.

Le film souple 8, de forme générale rectangulaire et symétrique par rapport au plan de symétrie de l'ensemble de la tête, comporte une petite portion rectangulaire 12, sensiblement de même largeur que le support de connexion 10 sur la portion d'extrémité 14 duquel, tournée vers le substrat 3, elle est fixée, par collage, vissage ou rivetage. Les portions 7 et 12 du film souple 8 sont raccordées par une portion 13, de forme trapézoïdale, s'élargissant depuis la portion 7.

Le substrat 3 porte donc des conducteurs, reliés aux éléments résistifs 15. Le film souple 8 porte également des conducteurs ou pistes conductrices, sur sa face tournée vers la plaquette 1: c'est un film souple simple face. Le support de connexion 10 porte aussi des conducteurs mais sur ses deux faces: c'est un circuit imprimé double face.

Il va maintenant être décrit comment ces conducteurs du substrat 3, du film souple 8 et du circuit imprimé 10 sont reliés entre eux.

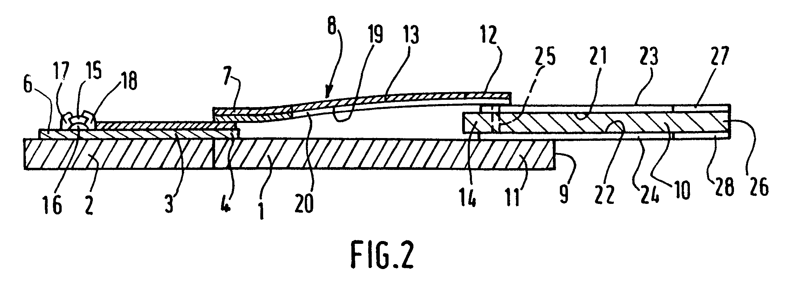

Soit, en référence à la figure 2, un des éléments résistifs 15 du substrat 3, alors que, par souci de clarté, tous les autres éléments 15 de la barrette 5 n'ont pas été représentés. Qu'il soit seulement rappelé que le plan de coupe de la figure 2 est parallèle au plan de symétrie de la tête et donc à la barrette 5.

L'élément résistif 15 a été déposé sur une languette 16 fixée sur le substrat 3. La languette 16 doit jouer un rôle de filtre thermique. En fonctionnement, elle sert de réflecteur réfléchissant les calories vers le support d'impression, non représenté, s'étendant parallèlement à la plaquette 1, de l'autre côté de l'élément résistif 15. A l'arrêt, elle sert, à l'inverse, de radiateur. L'élément résistif 15 est relié à deux conducteurs 17, 18, de préférence en or, dont l'un est relié à la masse. Une couche de protection recouvre généralement les éléments résistifs. D'un côté de la barrette d'éléments résistifs 15, tous les conducteurs 17, 18 s'étendent sur la céramique 3 sensiblement parallèlement les uns aux autres. Le plan de coupe de la figure 2 s'étend le long de l'un de ces conducteurs. Dans la pratique, un répartiteur de commande, au demeurant connu, pourra également être intégré sur le substrat 3, auquel seront reliés, d'un côté, les conducteurs 17, 18, et, de l'autre côté, d'autres conducteurs à relier par ailleurs aux pistes du film souple.

Le film souple 8 comporte, imprimées sur sa seule face 19 tournée vers la plaquette 1, un faisceau de pistes conductrices 20, relativement serrées au niveau de la portion d'extrémité 7, plus écartées au niveau de la portion d'extrémité 12, portions 7, 12 sous lesquelles les pistes s'étendent parallèlement les unes aux autres. Dans la portion 13 du film souple 8, elles divergent.

Toutes les pistes 20 du film souple 8 sont reliées à tous les conducteurs 17, 18 de la céramique 3, respectivement. Ainsi, la portion d'extrémité 7 du film souple 8 est pressée contre la portion d'extrémité 4 de la céramique 3 pour qu'un conducteur 17, 18 de la céramique 3 soit mécaniquement, et donc électriquement, réuni à une piste 20 du film souple 8. Sur la figure 2, sensiblement seule la partie de la piste 20, représentée, disposée sous la portion d'extrémité 7, s'étend dans le plan de coupe.

Le circuit imprimé 10, support de connexion, comporte sur ses deux faces 21, 22, deux groupes de conducteurs 23, 24, parallèles entre eux, et tous reliés aux pistes 20 du film souple 8, respectivement. Plus précisément, et le pas des conducteurs du circuit 10 étant ici le double de celui des pistes 20 du film souple, les conducteurs 23 sont reliés aux pistes 20 de rang impair et les conducteurs 24 aux pistes 20 de rang pair. Comme on le voit sur la figure 2, une piste 20 de rang pair est reliée à un conducteur 24, imprimé sur la face 22 du circuit 10 opposée à celle 21 qui est tournée vers le film souple 8 et le reçoit, par un trou métallisé 25 entre deux conducteurs 23.

Près de l'extrémité 26 du circuit 10, opposée à son extrémité 14, les conducteurs 23, 24 sont élargis pour former des bornes de contacts 27, 28.

On notera que, dans l'exemple représenté, le passage au système double face, par des traversées métallisées 25, est réalisé au droit de la zone de superposition du film souple 8 et du circuit de connexion 10. Il ne s'agit pourtant pas d'une caractéristique limitative de l'invention. La conversion de pas pourrait tout aussi bien s'effectuer ailleurs, par exemple bien au-delà de cette zone de superposition, vers le milieu du circuit 10. Dans ce cas, une piste 20 de rang pair du film 8 serait reliée à un conducteur 24 sur la face 22 par un trou métallisé et une portion de conducteur imprimée entre deux conducteurs 23 sur la face 21 et, elle, directement reliée à cette piste 20.

Ainsi, la tête d'écriture thermique, qui vient d'être décrite, comporte une partie de connecteur de type mâle 26, 27, 28 pouvant coopérer avec un connecteur de type femelle du commerce, à deux rangées de contacts à pas normalisé, par exemple de 2,54 mm.

Les démontage et remontage, et donc son interchangeabilité, sont aisés, directement par l'opérateur de l'imprimante, sans le moindre outillage.

En outre, les efforts de contacts, une fois la connexion des connecteurs effectuée, sont convenablement répartis et opposés.

On a décrit une tête à conducteurs imprimés sur le circuit 10 en nombre égal aux conducteurs imprimés sur le film 8 et à traversées alternées dans le circuit 10. Bien entendu, on ne sortirait pas du cadre de l'invention en adoptant des conducteurs sur le circuit 10 en nombre différent ou en n'associant pas ces conducteurs à ceux du film 8 deux à deux.

**Revendications**

1. .Tête d'écriture thermique de type série pour imprimante, comprenant un substrat (3), sur celui-ci, des éléments résistifs d'écriture (15) avec des conducteurs associés (17, 18), un support de connexion (10) à deux faces (21, 22), un film souple (8), porteur de pistes conductrices (20) reliées électriquement aux conducteurs (17, 18) du substrat (3), et solidaire, par ses deux portions d'extrémité (7, 12), du substrat (3) et du support de connexion (10), respectivement, caractérisée par le fait que les pistes (20) du film (8) sont imprimées sur une seule (19) de ses faces et le support de connexion double face (10) porte des conducteurs (23, 24), respectivement reliés électriquement aux pistes (20) du film (8), et imprimés sur ses deux faces (21, 22), les conducteurs (24), imprimés sur la face (22) du support de connexion (10) opposée à celle (21) tournée vers le film (8), étant reliés aux pistes (20) associées du film (8) par des trous métallisés (25).

2. Tête d'écriture selon la revendication 1, dans laquelle le pas des conducteurs (23, 24) imprimés sur le support de connexion (10) est plus grand que le pas des pistes (20) imprimées sur le film souple (8).

3. Tête d'écriture selon la revendication 1, dans laquelle les trous métallisés (25) sont ménagés au droit d'une zone de superposition du film (8) et du support de connexion (10).

4. Tête d'écriture selon la revendication 1, dans laquelle les trous métallisés sont ménagés sensiblement au milieu du support de connexion.

5. Tête d'écriture selon l'une des revendications 1 à 4, dans laquelle le substrat (3) des éléments résistifs (15) et le support imprimé de connexion (10) sont fixés sur une plaquette rigide (1).

## Patentansprüche

1. Serieller Thermoschreibkopf für einen Drucker, bestehend aus einem Substrat (3) mit, auf diesem, Widerstandsschreib-elementen (15) samt zugehörigen Leitern (17, 18), einer Zweiseitigen (21, 22) Verbindungsstütze (10), einer weichen Folie (8) als Träger leitender Bahnen (20), welche mit den Leitern (17, 18) des Substrats (3) elektrisch verbunden sind, und die durch ihre beiden Endstücke (7, 12) mit dem Substrat (3) bzw. der Verbindungsstütze (10) kraftschlüssig verbunden ist, dadurch gekennzeichnet, daß die Bahnen (20) der Folie (8) auf einer einzigen (19) ihrer Seiten bedruckt werden und die zweiseitige Verbindungsstütze (10) Leiter (23, 24) trägt, welche mit den zugehörigen Bahnen (20) der Folie (8) elektrisch verbunden sind und auf ihren beiden Seiten (21, 22) bedruckt werden, wobei die Leiter (24), welche auf der Seite (22) der Verbindungsstütze (10) bedruckt werden, die der Folie (8) zugewandten (21) gegenüberliegt, mit den zugehörigen Bahnen (20) der Folie (8) durch metallisierte Löcher (25) verbunden sind.

2. Schreibkopf gemäß Anspruch 1, bei welchem das Rastermaß der auf die Verbindungsstütze (10) gedruckten Leiter (23, 24) größer ist als das Rastermaß der auf die weiche Folie (8) gedruckten Bahnen (20).

3. Schreibkopf gemäß Anspruch 1, bei welchem die metallisierten Löcher (25) geradlinig in einem Bereich angebracht sind, wo die Folie (8) und die Verbindungsstütze (10) übereinanderliegen.

4. Schreibkopf gemäß Anspruch 1, bei welchem die metallisierten Löcher ungefähr in der Mitte der Verbindungsstütze angebracht sind.

5. Schreibkopf gemäß einem der Ansprüche 1 bis 4, bei welchem das Substrat (3) der Widerstands-Elemente (15) und die bedruckte Verbindungsstütze (10) auf einer starren Platte (1) befestigt sind.

## Claims

1. Thermal writing head of the series type for printer, comprising a substrate (3), on it, writing resistive elements (15) with associated conductors (17, 18), a connection support (10) with two faces (21, 22), a flexible film (8), bearing conducting tracks (20) electrically connected to the conductors (17, 18) of the substrate (3), and fast, by its two end portions (7, 12), with the substrate (3) and the connection support (10), respectively, characterized in that the tracks (20) of the film (8) are printed on just one (19) of its faces and the double face connection support (10) bears conductors (23, 24), respectively electrically connected to the tracks (20) of the film (8), and printed on its two faces (21, 22), the conductors (24), printed on the face (22) of the connection support (10) opposite that (21) facing the film (8), being connected to the associated tracks (20) of the film (8) through metallized holes (25).

2. Writing head as claimed in claim 1, wherein the pitch of the conductors (23, 24) printed on the connection support (10) is greater than the pitch of the tracks (20) printed on the flexible film (8).

3. Writing head as claimed in claim 1, wherein the metallized holes (25) are formed in line with a zone where the film (8) and the connection support (10) are superimposed.

4. Writing head as claimed in claim 1, wherein the metallized holes are formed substantially in the middle of the connection support.

5. Writing head as claimed in one of claims 1 to 4, wherein the substrate (3) of the resistive elements (15) and the connection support (10) are fixed to a rigid wafer (1).

FIG.1

FIG.2